# EUROPEAN PATENT SPECIFICATION

(11) **EP 3 783 803 B1**
(45) Date of publication and mention of the grant of the patent: **24.04.2024**
(21) Application number: 18917549.0
(22) Date of filing: 03.05.2018
(51) Int. Cl.: H03L 7/06, H03L 7/08, H03L 7/087, H03L 7/095

(54) **CLOCK DATA RECOVERY APPARATUS, OPTICAL MODULE AND OPTICAL LINE TERMINAL**
TAKTDATENRÜCKGEWINNUNGSVORRICHTUNG, OPTISCHES MODUL UND OPTISCHER LEITUNGSABSCHLUSS
APPAREIL DE RÉCUPÉRATION DE DONNÉES D'HORLOGE, MODULE OPTIQUE ET TERMINAL DE LIGNE OPTIQUE

(43) Date of publication of application: 24.02.2021
(73) Proprietor: Huawei Technologies Co., Ltd., Longgang Shenzhen, Guangdong 518129 (CN)
(72) Inventor: ZHENG, Jianyu, Shenzhen, Guangdong 518129 (CN); LI, Shengping, Shenzhen, Guangdong 518129 (CN); YU, Changliang, Shenzhen, Guangdong 518129 (CN); YE, Zhicheng, Shenzhen, Guangdong 518129 (CN)
(74) Representative: Grünecker Patent- und Rechtsanwälte PartG mbB
(86) International application number: PCT/CN2018/085400
(87) International publication number: WO 2019/210473

(56) References cited:
- CN-A- 102 611 440
- CN-A- 104 205 719
- CN-Y- 201 113 978
- US-A1- 2003 058 894
- US-A1- 2008 022 143
- US-A1- 2011 188 621
- US-A1- 2012 008 727
- US-A1- 2015 188 697
- US-A1- 2015 270 947
- US-B1- 9 419 783
- US-B2- 7 359 474
- AIQIN ZHANG: "Research and Design of High Speed Clock Recovery Circuit on ASIC", CHINA MASTER S THESES FULL-TEXT DATABASE, 15 December 2011 (2011-12-15), pages 1-74, XP055753344,
- ZHANG, AIQIN: "Research and Design of High Speed Clock Recovery Circuit on ASIC", China Master s Theses Full-text Database, 15 December 2011 (2011-12-15), pages 1-74, XP055753344,

## Description

### TECHNICAL FIELD

This application relates to the field of optical communications, and more specifically, to a clock data recovery apparatus, an optical module, and an optical line terminal.

### BACKGROUND

A passive optical network (passive optical network, PON) with a high symmetric transmission rate emerges against a backdrop of an increasing requirement for an uplink transmission rate. The passive optical network is an access network that uses optical fibers. In the PON, there is no power-driven electronic device between an optical line terminal (optical line terminal, OLT) and an optical network unit (optical network unit, ONU). Components used in the PON, including the optical fibers, an optical splitter, and like, are passive components.

In the passive optical network with the high symmetric transmission rate, a burst transmission mode is proposed to improve data transmission efficiency. Burst transmission, also referred to as data burst, is usually high-bandwidth data transmission within a short period of time. In the burst transmission mode, a plurality of data units may be transmitted as one unit (equivalent to one data block), to improve data transmission efficiency.

In the passive optical network with the high symmetric transmission rate, a clock data recovery (clock data recovery, CDR) technology may be used. To be specific, the OLT may recover clock information from data stream information, and sample data in the data stream information based on the recovered clock information.
US 2003/0058894 A1 discloses a method used to achieve auto-configuration involves automatically selecting a reference clock input appropriate to the line data rate and correctly configuring the internal logic of the device to correspond to the line data rate.
US 2015/270947 A1 discloses a circuit and method for referenceless clock and data recovery with improved efficiency and jitter tolerance by using an additional loop for frequency detection.
US 2012/008727 A1 provides a clock data recovery circuit that includes a phase locked loop unit, a delay locked loop unit and digital clock data recovery unit.
AIQIN ZHANG: "Research and Design of High Speed Clock Recovery Circuit on ASIC", CHINA MASTER S THESES FULL-TEXT DATABASE, 15 December 2011 (2011-12-15), pages 1-74, introduces an improved clock data recovery circuit.
US 2008/022143 A1 discloses a host receiver synchronizer for passive optical networks that includes a burst clock data recovery circuit. The burst clock data recovery circuit includes an adjustable oscillator for generating an output clock signal in response to a signal at an input thereof, a first comparator for comparing a frequency and a phase of the output clock signal to that of a reference signal and feeding back a first feedback signal to the oscillator input, and a second comparator for comparing the frequency and phase of the output clock signal to that of a data burst and feeding back a second feedback signal to the oscillator input once the output clock signal is locked in frequency with the reference signal.
US 2011/188621 A1 discloses an integrated circuit including clock and data recovery circuitry for recovering data information from an input serial data signal.
US 9 419 783 B1 discloses a phase detecting apparatus and a phase adjusting method to adjust a phase of a sampling clock signal used to sample a data signal.
US 2015/188697 A1 discloses a multimedia interface receiving circuit including a phase locked loop and four signal processing channels, each of which includes a phase detecting circuit.

How to implement the clock data recovery technology in the passive optical network with the high symmetric transmission rate is an urgent technical problem to be resolved.

### SUMMARY

This application provides a clock data recovery apparatus, an optical module, and an optical line terminal, to recover clock information from data stream information, and sample data in the data stream information based on the clock information. In this way, a clock data recovery technology is implemented.

According to a first aspect, this application provides a clock data recovery apparatus according to claim 1.

In the clock data recovery apparatus, the frequency oscillation unit is adjusted before a data stream signal, for example, a burst data stream arrives. Therefore, after the data stream arrives, the clock data recovery apparatus may quickly obtain a clock signal, to obtain a data signal in data based on the clock signal. In other words, the clock data recovery apparatus can greatly reduce a time for locking the clock signal, to improve working efficiency.

The data detection unit detects whether the data stream signal is input. When detecting that the data stream signal is not input, the data detection unit outputs the indication information to the frequency detection loop unit. In this way, the frequency detection loop unit outputs a signal to the frequency oscillation unit before the data stream signal is input, to adjust the frequency oscillation unit. This helps reduce the locking time. Before the data detection unit detects whether the data stream signal is input, the signal output by the frequency oscillation unit can be very close to the data stream signal in frequency. Therefore, the time for locking the clock signal based on the data stream signal after the data stream signal is input can be further reduced, and the clock data recovery apparatus can collect data stream signals in a larger frequency range.

In a first possible implementation, a length of consecutive identical digits in the data stream signal is less than or equal to a preset first threshold.

The clock data recovery apparatus can tolerate consecutive identical digits with a specific length.

With reference to any one of the first aspect or the first possible implementations, in a second possible implementation, the phase detection loop unit includes a delay line unit, a first mixer, a second mixer, a voltage-to-current converter, and a first filter.

The delay line unit is configured to delay the data stream signal. The first mixer is configured to perform frequency mixing on a signal obtained after delaying performed by the delay line unit and the data stream signal to obtain a first signal. The second mixer is configured to perform frequency mixing on the first signal and the signal output by the frequency oscillation unit to obtain the phase difference. The voltage-to-current converter is configured to: when the data stream signal is input to the clock data recovery apparatus, convert the phase difference to a first current signal. The first filter is configured to convert the first current signal to the second voltage signal.

With reference to the second possible implementation, in a third possible implementation, the frequency detection loop unit further includes a first multiplexer, a second multiplexer, a delay calibration unit, and a first clock divider.

The first frequency divider is configured to divide a frequency of the signal output by the frequency oscillation unit by 2, to obtain a first frequency-divided signal and a second frequency-divided signal.

The delay calibration unit is configured to: after receiving the first indication signal, output a third indication signal to the first multiplexer and the second multiplexer.

The first multiplexer is configured to: after receiving the third indication signal, choose to output the first frequency-divided signal to the delay line unit.

The second multiplexer is configured to: after receiving the third indication signal, choose to output the second frequency-divided signal.

The delay calibration unit is further configured to: receive a signal output by the delay line unit and a signal output by the second multiplexer, and when a delay between the signal output by the delay line unit and the signal output by the second multiplexer is greater than a preset delay threshold, output a fourth indication signal to the delay line unit.

The delay line unit is configured to adjust a delay time based on the fourth indication signal.

The delay calibration unit is further configured to: when the delay between the signal output by the delay line unit and the signal output by the second multiplexer is less than or equal to the preset delay threshold, output a fifth indication signal to the first multiplexer and the second multiplexer, and output sixth indication signal to the data detection unit.

The first multiplexer is further configured to: after receiving the fifth indication signal, choose to output the data stream signal to the delay calibration unit.

The second multiplexer is further configured to: after receiving the fifth indication signal, choose to output the data stream signal to the delay calibration unit.

The data detection unit is specifically configured to: after receiving the sixth indication signal, start to detect whether the data stream signal is input to the clock data recovery apparatus.

With reference to any one of the first aspect or the foregoing possible implementations, in a fourth possible implementation, a frequency of the reference clock signal is 1/N of the frequency of the data stream signal.

The clock data recovery apparatus further includes a frequency division unit. The frequency division unit is configured to: divide the frequency of the signal output by the frequency oscillation unit by N to obtain a third frequency-divided signal, and output the third frequency-divided signal to the frequency detection loop unit.

The frequency detection loop unit is specifically configured to: when the data stream signal is not input to the clock data recovery apparatus, determine a frequency difference between the reference clock signal and the third frequency-divided signal, and use the frequency difference as the first frequency difference.

In this implementation, the frequency divider performs frequency division on the signal output by the frequency oscillation unit, so that a frequency of a frequency-divided signal is equivalent to the frequency of the reference clock signal. Therefore, the frequency-divided signal can be compared with the reference clock signal. In this way, the frequency oscillation unit can also be adjusted based on a reference clock signal with a relatively low output frequency. This can reduce complexity of the apparatus and costs.

According to a second aspect, this application provides an optical module. The optical module includes the clock data recovery apparatus according to any one of the first aspect or implementations of the first aspect.

According to a third aspect, this application provides an optical line terminal. The optical line terminal includes the clock data recovery apparatus according to any one of the first aspect or implementations of the first aspect, or the optical module according to the second aspect.

According to a fourth aspect, this application provides a passive optical network communications system. The communication system includes the optical line terminal according to the second aspect.

### BRIEF DESCRIPTION OF DRAWINGS

FIG. 1 is a schematic architectural diagram of a passive optical network communications system to which a clock data recovery apparatus according to an embodiment of this application can be applied;
FIG. 2 is a schematic structural diagram of a clock data recovery apparatus according to an example, not covered by the scope of the claimed invention but useful for understanding the invention; of this application;
FIG. 3 is a schematic structural diagram of a clock data recovery apparatus according to another embodiment of this application;
FIG. 4 is a schematic structural diagram of a clock data recovery apparatus according to still another embodiment of this application;
FIG. 5 is a schematic structural diagram of a clock data recovery apparatus according to yet another embodiment of this application;
FIG. 6 is a schematic structural diagram of an optical module according to an embodiment of this application; and
FIG. 7 is a schematic structural diagram of an optical line terminal according to an embodiment of this application.

### DESCRIPTION OF EMBODIMENTS

The following describes the technical solutions of this application with reference to the accompanying drawings.

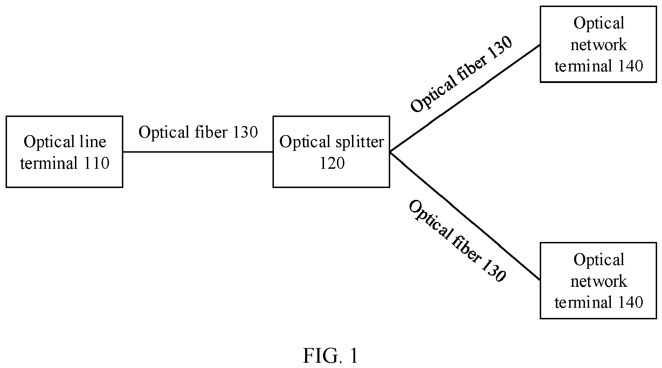

As shown in FIG. 1, a passive optical network communications system according to an embodiment of this application may include an optical line terminal 110, an optical splitter 120, optical fibers 130, and optical network terminals 140.

The optical line terminal 110 is a terminal in a central office of a service provider on a passive optical network. The optical network terminal 140 is customer-premises equipment on the passive optical network. The optical fibers 130 are configured to transmit an optical signal. The optical splitter 120 may also be referred to as a splitter, configured to split a trunk line and an optical signal at any point along a path to a multi-point tree topology.

An example of the optical line terminal 110 is an OLT, and an example of the optical network terminal 140 is an ONU.

After the optical network terminal 140 sends a data stream signal (for example, burst data) to the optical line terminal 110, the optical line terminal 110 may obtain a clock signal based on the data stream signal, and collect a data signal in the data stream signal based on the clock signal. In other words, the optical line terminal 110 may collect the data signal by using a clock recovery technology.

This application first provides a clock data recovery apparatus, so that an optical line terminal to which the clock data recovery apparatus is applied can collect a data signal by using a clock recovery technology.

It should be understood that the clock data recovery apparatus provided in this application may also be applied to another communications system or application scenario in which a data signal needs to be collected by using the clock recovery technology. This is not limited in this application.

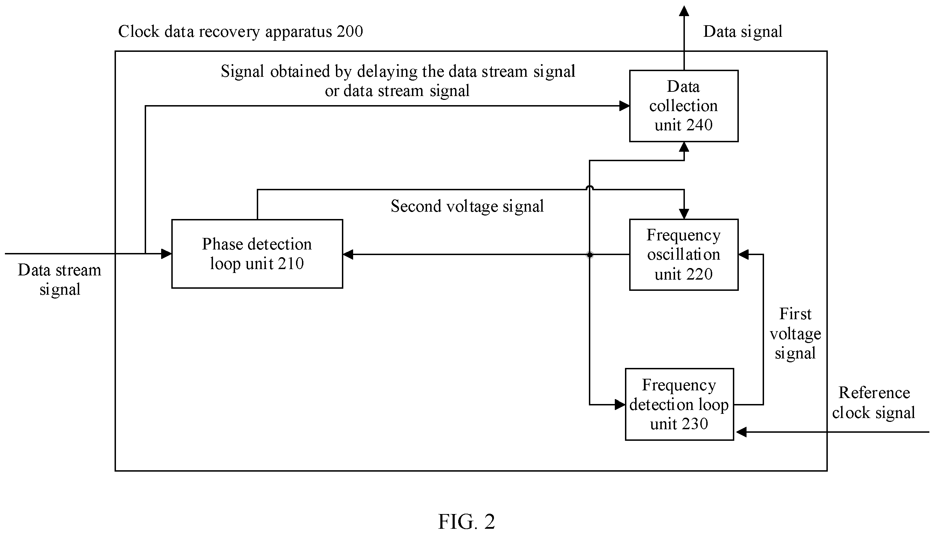

FIG. 2 is a schematic structural diagram of a clock data recovery apparatus 200 according to an example, not covered by the scope of the claimed invention but useful for understanding the invention. The clock data recovery apparatus 200 includes a phase detection loop unit 210, a frequency oscillation unit 220, a frequency detection loop unit 230, and a data collection unit 240. It should be understood that the units may be directly connected, or may be connected through another unit or a component.

The frequency detection loop unit 230 is configured to: when a data stream signal is not input to the clock data recovery apparatus 210, determine a first frequency difference between a reference clock signal and a signal output by the frequency oscillation unit, generate a first voltage signal based on the first frequency difference, and output the first voltage signal.

Generating a first voltage signal based on the first frequency difference may be understood as: generating a first voltage signal corresponding to the first frequency difference, or generating a first voltage signal that can represent the first frequency difference.

The frequency oscillation unit 220 is configured to: oscillate the first voltage signal output by the frequency detection loop unit 230, and output a signal obtained by oscillating the first voltage signal.

When being powered on or supplied with power, the frequency oscillation unit 220 may perform oscillation and output an oscillation signal. After the first voltage signal is input, the frequency oscillation unit 220 adjusts oscillation based on the first voltage signal, to adjust a frequency of the output signal.

The phase detection loop unit 220 is configured to: when a data stream signal is input to the clock data recovery apparatus 200, determine a phase difference between the data stream signal and a signal output by the frequency oscillation unit 220, generate a second voltage signal based on the phase difference, and output the second voltage signal.

Generating a second voltage signal based on the phase difference may be understood as: generating a second voltage signal corresponding to the phase difference, or generating a second voltage signal that can represent the phase difference.

The frequency oscillation unit 220 is further configured to: adjust oscillation based on the second voltage signal output by the phase detection loop unit 210, and output a signal obtained after oscillation is adjusted based on the second voltage signal.

When being powered on or supplied with power, the frequency oscillation unit 220 may perform oscillation and output an oscillation signal. After the second voltage signal is input, the frequency oscillation unit 220 adjusts oscillation based on the second voltage signal, to adjust a frequency of the output signal.

The data collection unit 240 is configured to collect, by using the signal obtained after the frequency oscillation unit 220 performs oscillation based on the second voltage signal as a clock signal, a data signal in the data stream signal input to the clock data recovery apparatus 200 or in a signal obtained by delaying the data stream signal.

A frequency of the reference clock signal may be the same as a frequency of the data stream signal. In this case, after the clock data recovery apparatus 200 is powered on, a working procedure of the clock data recovery apparatus 200 may include the following two steps.

Step 1: When the data stream signal is not input to the clock data recovery apparatus, for example, in a guard time between two burst signals or when the clock data recovery apparatus is just powered on, the frequency detection loop unit 230 receives the reference clock signal and the signal output by the frequency oscillation unit 220, and obtains a frequency difference (which may be referred to as the first frequency difference) between the reference clock signal and the signal output by the frequency oscillation unit 220 (the frequency oscillation unit 220 may perform oscillation and output a signal after being powered on). Then, the frequency detection loop unit 230 generates a voltage signal (which may be referred to as the first voltage signal) based on the first frequency difference, and outputs the first voltage signal to the frequency oscillation unit 220. The frequency oscillation unit 220 receives the first voltage signal, adjusts oscillation based on the first voltage signal, and outputs, to the frequency detection loop unit 230, a signal obtained after oscillation is adjusted.

Step 1 may be repeatedly performed. When step 1 is repeated, an oscillation frequency of the frequency oscillation unit 220 is adjusted based on a frequency of the signal output by the frequency oscillation unit 220 and the frequency of the reference clock signal. Then, the frequency oscillation unit 220 can obtain, through oscillation, a signal whose frequency is increasingly close to the frequency of the data stream signal.

Step 2: When the data stream signal is input to the clock data recovery apparatus 200, for example, when a burst signal is input to the clock data recovery apparatus, the phase detection loop unit 210 receives the data stream signal and the signal output by the frequency oscillation unit 220 (the frequency oscillation unit 220 may perform oscillation and output a signal after being powered on, or the frequency oscillation unit 220 adjusts oscillation based on the first voltage signal output by the frequency detection loop unit 230 and outputs a signal), and obtains a phase difference between the data stream signal and the signal output by the frequency oscillation unit 220. Then, the phase detection loop unit 210 generates a voltage signal (which may be referred to as the second voltage signal) based on the phase difference, and outputs the second voltage signal to the frequency oscillation unit 220. The frequency oscillation unit 220 receives the second voltage signal, adjusts oscillation based on the second voltage signal, and outputs, to the phase detection unit, a signal obtained after oscillation is adjusted.

Step 2 may be repeatedly performed. When step 2 of the procedure is repeated, the oscillation frequency of the frequency oscillation unit 220 is adjusted based on the phase difference between the signal output by the frequency oscillation unit 220 and the data stream signal. Then, the frequency oscillation unit 220 can obtain, through oscillation, a signal whose frequency is closer to a frequency of the data stream signal. For example, when the phase difference between the signal output by the frequency oscillation unit 220 and the data stream signal is zero, the second voltage signal output by the phase detection loop unit 210 may be zero, and the frequency oscillation unit 220 may stop adjusting the oscillation frequency. In this case, the frequency of the signal output by the frequency oscillation unit 220 may be considered as equivalent to the frequency of the data stream signal, so that the signal output by the frequency oscillation unit 220 may be used as the clock signal for collecting the data signal.

In the clock data recovery apparatus 200 shown in FIG. 2, the frequency oscillation unit may be adjusted before a data stream, for example, a burst data stream arrives. Therefore, after the data stream arrives, the clock data recovery apparatus 200 may quickly obtain a clock signal, to obtain a data signal in data based on the clock signal. In other words, the clock data recovery apparatus 100 can greatly reduce a time for locking the clock signal, to improve working efficiency.

In addition, the phase detection loop unit 210 uses, as a clock signal of the data collection unit, the signal obtained after oscillation is adjusted based on the second voltage signal, so that the data collection unit collects a data signal based on the clock signal.

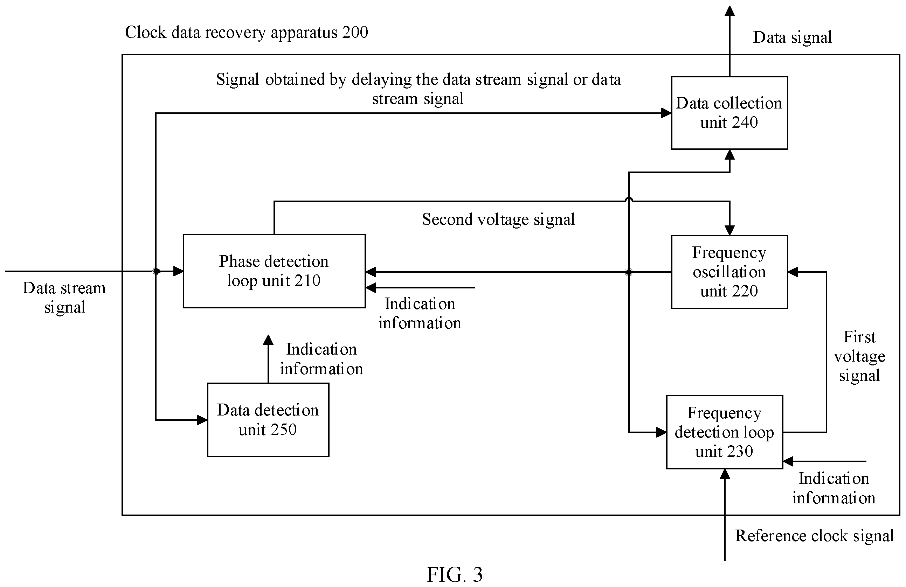

As shown in FIG. 3, the clock data recovery apparatus 200 further includes a data detection unit 250. It should be understood that the units may be directly connected, or may be connected through another unit or a component.

The data detection unit 250 is configured to: detect whether the data stream signal is input to the clock data recovery apparatus 200; and when detecting that the data stream signal is not input to the clock data recovery apparatus 200, output first indication information to the frequency detection loop unit 230, where the first indication information is used to indicate that the data stream signal is not input to the clock data recovery apparatus 200; or when detecting that the data stream signal is input to the clock data recovery apparatus 200, output second indication information to the phase detection loop unit 210, where the second indication information is used to indicate that the data stream signal is input to the clock data recovery apparatus 200.

In other words, in the clock data recovery apparatus 200 shown in FIG. 3, the data detection unit 250 detects whether the data stream signal is input to the clock data recovery apparatus. Then, the phase detection loop unit 210 and the frequency detection loop unit 230 obtain an indication information indicating whether the data stream signal is input to the clock data recovery apparatus, and work based on the indication information.

In some possible implementations, when the data detection unit 250 detects whether the data stream signal is input to the clock data recovery apparatus, if the data detection unit 250 detects consecutive identical digits (consecutive identical digit, CID), and a length of the CIDs meets a preset first condition, the data detection unit 250 may consider that the data stream signal is not input to the clock data recovery apparatus 200, that is, the data detection unit 250 may output the first indication information. On the contrary, if the data detection unit 250 detects the CIDs, and the length of the CIDs does not meet the preset first condition, the data detection unit 250 may consider that the data stream signal is input to the clock data recovery apparatus 200, that is, the data detection unit 250 may output the second indication information.

The first condition may include: the length of the CIDs is greater than or equal to a preset first threshold, or the length of the CIDs is greater than a preset second threshold.

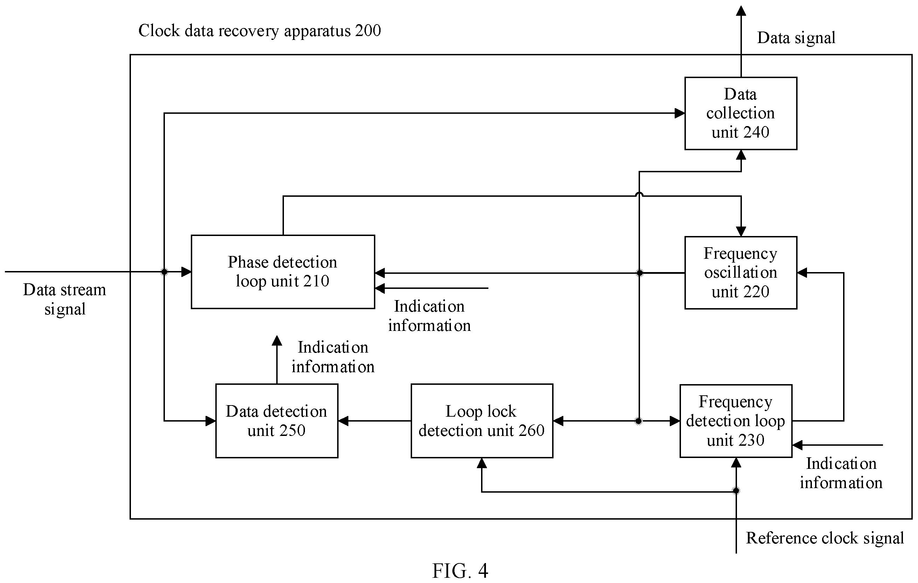

As shown in FIG. 4, in some possible implementations, the clock data recovery apparatus 200 further includes a loop lock detection unit 260. It should be understood that the units may be directly connected, or may be connected through another unit or a component.

The loop lock detection unit 260 is configured to: determine a second frequency difference between the reference clock signal and the signal output by the frequency oscillation unit 220, and when determining that the second frequency difference is less than or equal to a preset second threshold, output a first indication signal.

In this case, the data detection unit 250 is specifically configured to: when the loop lock detection unit 260 outputs the first indication signal, start to detect whether the data stream signal is input to the clock data recovery apparatus 200.

In the clock data recovery apparatus 200 shown in FIG. 4, it can be further ensured that when the data detection unit 250 outputs a second indication signal to the phase detection unit 210, the frequency detection loop unit 230 obtains the clock signal from the frequency oscillation unit 220, to further reduce the locking time.

In some possible implementations, the phase detection loop unit 210 in the clock data recovery apparatus 200 may include a delay line unit, a first mixer (mixer), a second mixer, a voltage-to-current converter (VII), and a first filter. The voltage-to-current converter may further include a phase detector (phase detector, PD).

The delay line unit is configured to delay the data stream signal. The first mixer is configured to perform frequency mixing on a signal obtained after delaying performed by the delay line unit and the data stream signal to obtain a first signal. The second mixer is configured to perform frequency mixing on the first signal and the signal output by the frequency oscillation unit 220 to obtain the phase difference. The voltage-to-current converter is configured to: when the data stream signal is input to the clock data recovery apparatus 200, convert the phase difference to a first current signal. The first filter is configured to convert the first current signal to the second voltage signal.

The frequency oscillation unit 220 includes M frequency oscillators and a multiplexing unit, where M is an integer greater than or equal to 2. The frequency of the data stream signal falls within a total frequency range of signals that can be output by all of the M frequency oscillators. In other words, the total frequency range of the signals that can be output by all of the M frequency oscillators should include the frequency of the data stream signal. For example, when M is equal to 2, a first frequency oscillator can output signals of 24 GHz to 26 GHz, and a second frequency oscillator can output signals of 26 GHz to 28 GHz. Then, the frequency of the input data stream signal should be between 24 GHz and 28 GHz.

Each of the M frequency oscillators is configured to: oscillate the first voltage signal output by the frequency detection loop unit 230, and output a signal obtained by oscillating the first voltage signal.

The loop lock detection unit 260 is configured to output a second indication signal to the multiplexing unit based on the second frequency difference between the reference clock signal and the signal output by the frequency oscillation unit 220.

The multiplexing unit is configured to select, based on the second indication signal, a signal output by an i^{th} frequency oscillator in the M frequency oscillators as an output signal of the frequency oscillation unit 220, where a frequency difference between the signal output by the i^{th} frequency oscillator and the data stream signal is less than or equal to a preset threshold.

In this implementation, the frequency oscillation unit 220 of the clock data recovery circuit 200 includes a plurality of frequency oscillators, and frequency ranges of signals that can be output by the oscillators are different. In addition, the loop lock detection unit 260 selects, from the plurality of oscillators, an oscillator that can output a frequency that meets a frequency requirement of the data stream signal, and lock the frequency oscillator or lock the frequency of the signal output by the frequency oscillation unit 230. Therefore, data stream signals in a larger frequency range can be input to the clock data recovery apparatus.

When the frequency oscillation unit 220 includes the M frequency oscillators and the multiplexing unit, in some possible implementations, the frequency detection loop unit 210 may further include a first multiplexer, a second multiplexer, a delay calibration unit, and a first frequency divider.

The first frequency divider is configured to divide the frequency of the signal output by the frequency oscillation unit 220 by 2, to obtain a first frequency-divided signal and a second frequency-divided signal.

The delay calibration unit is configured to: after receiving the first indication signal output by the loop lock detection unit 260, output a third indication signal to the first multiplexer and the second multiplexer.

The first multiplexer is configured to: after receiving a fifth indication signal output by the delay calibration unit, choose to output the first frequency-divided signal to the delay line unit.

The second multiplexer is configured to: after receiving the fifth indication signal output by the delay calibration unit, choose to output the second frequency-divided signal, where the second frequency-divided signal is delayed by 1/2 of a transmission cycle of the data stream signal relative to the first frequency-divided signal.

The delay calibration unit is further configured to: receive a signal output by the delay line unit and a signal output by the second multiplexer, and when a delay between the signal output by the delay line unit and the signal output by the second multiplexer is greater than a preset delay threshold, output a fourth indication signal to the delay line unit.

The delay line unit is configured to adjust a delay time based on the fourth indication signal.

The delay calibration unit is further configured to: when the delay between the signal output by the delay line unit and the signal output by the second multiplexer is less than or equal to the preset delay threshold, output the fifth indication signal to the first multiplexer and the second multiplexer, and output a sixth indication signal to the data detection unit 250.

The first multiplexer is further configured to: after receiving the fifth indication signal, choose to output the data stream signal to the delay calibration unit.

The second multiplexer is further configured to: after receiving the fifth indication signal, choose to output the data stream signal to the delay calibration unit.

The data detection unit 250 is specifically configured to: after receiving the sixth indication signal, start to detect whether the data stream signal is input to the clock data recovery apparatus 200.

When the frequency of the data stream signal is relatively high, relatively high costs are generally incurred in providing a reference clock signal with a relatively high frequency. Therefore, to reduce implementation complexity and costs, the frequency of the reference clock signal may be different from the frequency of the data stream signal. For example, the frequency of the reference clock signal may be 1/N of the frequency of the data stream signal.

In this case, in some possible implementations, the clock data recovery apparatus 200 may further include a frequency division unit. The frequency division unit is configured to: divide the frequency of the signal output by the frequency oscillation unit 220 by N to obtain a third frequency-divided signal, and output the third frequency-divided signal to the frequency detection loop unit 230.

In this case, the frequency detection loop unit 210 may be specifically configured to: when the data stream signal is not input to the clock data recovery apparatus 200, determine a frequency difference between the reference clock signal and the third frequency-divided signal, and use the frequency difference as the first frequency difference.

In this implementation, the delay calibration unit may implement self-calibration on a delay of the data stream signal, to help improve efficiency of obtaining the clock signal and accuracy of the clock signal.

It should be understood that in the clock data recovery apparatus 200 in this embodiment of this application, the units or components further included in the units may be coupled to each other, to reduce costs and a size of the clock data recovery apparatus 200.

For example, when the frequency of the reference clock signal is 1/64 of the frequency of the data stream signal, the frequency division unit may include one 1/2 frequency divider and one 1/32 frequency divider. The 1/2 frequency divider and the first frequency divider in the frequency detection loop unit 130 may be a same frequency divider, where the first frequency divider in the frequency detection loop unit 130 is configured to divide the frequency of the signal output by the frequency oscillation unit 120 by 2, to obtain the first frequency-divided signal and the second frequency-divided signal.

For another example, the frequency detection loop unit 230 may include a phase frequency detector (phase frequency detector, PFD) and charge pump (charge pump, CP) unit, and a filter. This filter and the filter in the phase detection loop unit 210 may be a same filter.

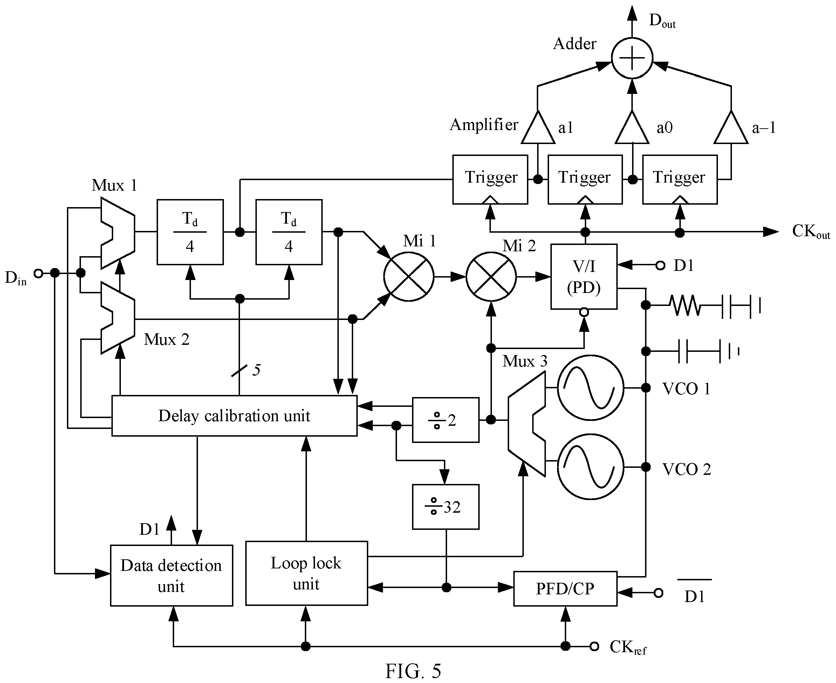

With reference to FIG. 5, the following describes an example circuit connection diagram of a clock data recovery apparatus according to an embodiment of this application.

In FIG. 5, a clock data recovery circuit 200 includes a phase detection loop unit, a frequency oscillation unit, a frequency detection loop unit, a data collection unit, a data detection unit, and a loop lock unit.

The phase detection loop unit includes a first multiplexer (Mux 1), a second multiplexer (Mux 2), a delay calibration unit, a first frequency divider (a 1/2 frequency divider), delay line units (including two T_{d}/4 delay line units), a first mixer (Mi 1), a second mixer (Mi 2), a voltage-to-current converter (VII), and a first filter. T_{d} is a time cycle corresponding to a frequency of a data stream signal.

The frequency oscillation unit includes two voltage-controlled oscillators (a VCO 1 and a VCO 2) and a multiplexing unit. The multiplexing unit includes a multiplexer (Mux 3).

A frequency of a reference clock signal may be 1/64 of the frequency of the data stream signal.

A frequency division unit includes one 1/2 frequency divider and one 1/32 frequency divider. The 1/2 frequency divider and the first frequency divider in the frequency detection loop unit 130 are a same frequency divider, where the first frequency divider in the frequency detection loop unit is configured to divide a frequency of a signal output by the frequency oscillation unit 220 by 2.

The frequency detection loop unit includes a PFD/CP unit and a filter. This filter and the first filter in the phase detection loop unit are a same filter.

The data collection unit includes three triggers, amplifiers corresponding to the three triggers, and an adder.

An example working procedure of the clock data recovery apparatus in FIG. 5 may include the following steps.

Step 1: The clock data recovery apparatus is initially powered on.

After the clock data recovery apparatus is supplied with power, the VCO 1 and VCO 2 start to perform oscillation and output oscillated signals. Indication information (D1) input by the data detection unit may be false, to indicate that a data stream signal is not input to the clock data recovery apparatus. The loop lock unit may output initial second indication information to the multiplexer 3 (Mux 3), and the Mux 3 chooses, based on the initial second indication information, to output the signal obtained after oscillation performed by the VCO 1 in the VCO 1 or the VCO 2. A frequency of the signal output by the VCO 1 is lower than a frequency of the signal output by the VCO 2.

Step 2: After receiving the D1, the VII (PD) may not perform current conversion. After receiving a information indicating to reverse the D1 (that is, true), the PFD/CP may start to work. To be specific, the PFD/CP may determine a frequency difference between a reference clock signal (CK_{ref}) and a signal obtained after the signal output by the Mux 3 is processed by the 1/2 frequency divider and the 1/32 frequency divider, and generate a current signal based on the frequency difference. The filter converts the current signal to a first voltage signal.

The VCO 1 adjusts oscillation based on the first voltage signal, and outputs a signal obtained after oscillation is adjusted. The Mux 3 outputs, as indicated by the loop lock unit and to the 1/2 frequency divider, the signal obtained after the VCO 1 adjusts oscillation.

The 1/2 frequency divider and the 1/32 frequency divider perform frequency division on the signal obtained after the VCO 1 adjusts oscillation, to obtain a signal. The obtained signal is input to both the PFD/CP and the loop lock unit.

The loop lock unit determines a frequency difference between the reference clock signal (CK_{ref}) and the signal obtained after processing performed by the 1/2 frequency divider and the 1/32 frequency divider. When the frequency difference decreases and is less than or equal to one thousand parts per million (1000 ppm), the loop lock unit locks a frequency of the VCO 1, in other words, subsequently controls the Mux 3 to output a signal obtained after oscillation performed by the VCO 1. When the frequency difference increases, the loop lock unit outputs new second indication information to the Mux 3, and the Mux 3 chooses, based on the second indication information, to output a signal obtained after oscillation performed by the VCO 2. A signal obtained after the signal output by the Mux 3 is processed by the 1/2 frequency divider and the 1/32 frequency divider is input to the loop lock unit.

After the Mux 3 selects the VCO 2, the loop lock unit determines a frequency difference between the reference clock signal (CK_{ref}) and the signal obtained after the signal output by the Mux 3 is processes by the 1/2 frequency divider and the 1/32 frequency divider. When the frequency difference decreases and is less than or equal to 1000 ppm, the loop lock unit locks a frequency of the VCO 2, in other words, subsequently controls the Mux 3 to output a signal obtained after oscillation performed by the VCO 2.

In step 2, an oscillation frequency of a frequency oscillator may be initialized, to ensure that an oscillation frequency of the VCO 1 or VCO 2 is already similar to a rate of a to-be-transmitted data stream signal (in other words, is approximate to the rate of the data stream signal).

Step 3: After locking the VCO, the loop lock unit outputs a first indication signal to the delay calibration unit.

After receiving the first indication signal, the delay calibration unit outputs a third indication signal to the Mux 1 and the Mux 2; and outputs, to the Mux 1, a first frequency-divided signal output by the 1/2 frequency divider to the delay calibration unit, and outputs, to the Mux 2, a second frequency-divided signal output by the 1/2 frequency divider to the delay calibration unit.

Step 4: After receiving the third indication signal, the Mux 1 outputs the first frequency-divided signal to a first T_{d}/4 delay line unit. After receiving the third indication signal, the Mux 2 outputs the second frequency-divided signal to the delay calibration unit.

After delaying the first frequency-divided signal by T_{d}/4, the first T_{d}/4 delay line unit obtains a first delayed signal, and outputs the first delayed signal to a second T_{d}/4 delay line unit. After delaying the first delayed signal by T_{d}/4, the second T_{d}/4 delay line unit obtains a second delayed signal, and outputs the second delayed signal to the delay calibration unit.

After receiving the second delayed signal and receiving the second frequency-divided signal from the Mux 2, the delay calibration unit outputs a fourth indication signal to the two T_{d}/4 delay line units based on a delay between the second delayed signal and the second frequency-divided signal. In FIG. 5, an oblique line and a number "5" that are between the delay calibration unit and the T_{d}/4 delay line units indicate that the fourth indication signal is a 5-bit signal. It should be understood that the five bits are merely an example.

After receiving the fourth indication signal, the two T_{d}/4 delay line units adjust a delay time.

Step 4 is repeated until a delay of the second frequency-divided signal relative to a second delayed signal output by the second T_{d}/4 delay line unit to the delay calibration unit is half of a transmission cycle of the data stream signal.

Step 5: After the delay of the second frequency-divided signal relative to the second delayed signal output by the second T_{d}/4 delay line unit to the delay calibration unit is half of the transmission cycle of the data stream signal, the delay calibration unit outputs a sixth indication signal to the data detection unit, and outputs a fifth indication signal to the Mux 1 and the Mux 2.

After receiving the fifth indication signal, the Mux 1 chooses to output the data stream signal to the first T_{d}/4 delay line unit. After receiving the fifth indication signal, the Mux 2 chooses to output the data stream signal to the Mi 1.

After receiving the sixth indication signal, the data detection unit starts to detect whether a data stream signal is input to the clock data recovery apparatus.

Step 6: When the data detection unit detects that the data stream signal (Dᵢₙ) is input to the clock data recovery apparatus, D1 output by the data detection unit is used to indicate that the data stream signal is input to the clock data recovery apparatus (for example, D1 is true).

The data stream signal is input to the Mux 1, and is delayed by the two T_{d}/4 delay line units. A delayed signal is input to the Mi 1.

The data stream signal input to the Mux 1 is directly input to the Mi 1. The Mi1 performs frequency mixing on the delayed data stream signal and the original data stream signal, and outputs a first frequency-mixed signal, where the first frequency-mixed signal includes phase information of the data stream signal.

Step 7: The first frequency-mixed signal and a signal that is obtained after oscillation performed by the VCO 1 or the VCO 2 and that the Mux 3 chooses to output are both input to the Mi 2. The Mi 2 performs frequency mixing on the two signals, and outputs an obtained second frequency-mixed signal to the V/I (PD).

The V/I (PD) performs phase detection on the second frequency-mixed signal, and generates a current signal based on a detected phase. The filter converts the current signal to a second voltage signal.

The second voltage signal is input to the locked VCO 1 or VCO 2. The VCO 1 or the VCO 2 adjusts oscillation based on the second voltage signal, and a frequency of a signal obtained after oscillation is adjusted should be closer to a frequency of the data stream signal.

Step 7 is repeated until a phase that is detected by the VII (PD) and that is of the second frequency-mixed signal is 0. In this case, the VCO 1 or the VCO 2 may no longer adjust oscillation. In other words, a frequency of a signal output by the VCO 1 or the VCO 2 no longer changes. In this case, the signal output by the VCO 1 or the VCO 2 may be considered as a recovered clock signal.

Step 8: The VCO 1 or the VCO 2 outputs the clock signal to the V/I (PD) through the Mux 3, and the V/I (PD) outputs the clock signal to the triggers. It should be understood that the VCO 1 or the VCO 2 may alternatively output the clock signal directly to the triggers through the Mux 3. In this case, the signal output by the VCO 1 or the VCO 2 enters the V/I (PD) through a NOT gate, and then enters the triggers. A duty cycle of the obtained clock signal may be adjusted.

Step 9: After receiving the clock signal (CK_{OUT}), the triggers may sample, based on the clock signal, a signal obtained after delaying performed by the first T_{d}/4 delay line unit.

The amplifier amplifies a signal obtained after sampling performed by the corresponding trigger. The adder processes amplified signals to obtain a data signal (D_{OUT}).

In step 7 to step 9, the clock data recovery apparatus may be in a frequency data recovery mode.

Step 10: When the clock data recovery apparatus is in a guard interval between data stream signals, in other words, when the data detection unit detects that a data stream signal is not input to the clock data recovery apparatus, the D1 output by the data detection unit is used to indicate that the data stream signal is not input to the clock data recovery apparatus .

After receiving the D1, the V/I (PD) may not perform current conversion. After receiving a information indicating to reverse the D1 (that is, true), the PFD/CP may start to work. To be specific, the PFD/CP may determine a frequency difference between a reference clock signal (CK_{ref}) and a signal obtained after a signal output by the Mux 3 is processed by the 1/2 frequency divider and the 1/32 frequency divider, and output a current signal based on the frequency difference.

The filter converts the current signal to a first voltage signal. The VCO 1 or the VCO 2 adjusts oscillation based on the first voltage signal, and outputs a signal obtained after oscillation is adjusted. In this case, a clock signal received by the trigger is a signal obtained after oscillation is adjusted based on the first voltage signal.

In step 10, the clock data recovery apparatus is in a frequency detection loop (FD-Loop) mode.

In other words, when a data stream signal is transmitted, the clock data recovery apparatus 100 is in the frequency data recovery mode. The phase detection loop unit based on a delay and frequency mixing technology determines a phase difference between frequencies of the data stream signal and a signal output by the frequency oscillator, to implement clock frequency recovery. If the clock data recovery apparatus is in a guard interval of burst data, the clock data recovery apparatus switches to the frequency detection loop mode. In this case, a frequency of a signal output by the VCO, namely, an oscillation frequency of the VCO is locked based on an external reference clock signal to a frequency approximate to a transmission rate of the data stream signal. The entire clock data recovery apparatus 100 is in a waiting mode until next burst data arrives. Then, the clock data recovery apparatus returns to the frequency data recovery mode, to ensure that locking can be completed in an extremely short time in a burst mode.

In addition, the data detection unit may count CIDs in the data stream signal based on the reference clock signal (CK_{ref}). If a length of the CIDs is less than or equal to a preset threshold, the data detection unit may consider that the data stream signal is not input to the clock data recovery apparatus, in other words, the D1 output by the data detection unit may be used to indicate that the data stream signal is not input to the clock data recovery apparatus. Otherwise, the D1 output by the data detection unit may be used to indicate that the data stream signal is input to the clock data recovery apparatus. In this way, CIDs with a specific length can be tolerated.

It should be understood that a clock signal used by the data detection unit for counting may not be the reference clock signal, but a clock signal of another frequency. The data detection unit uses the reference clock signal for counting, to reduce complexity.

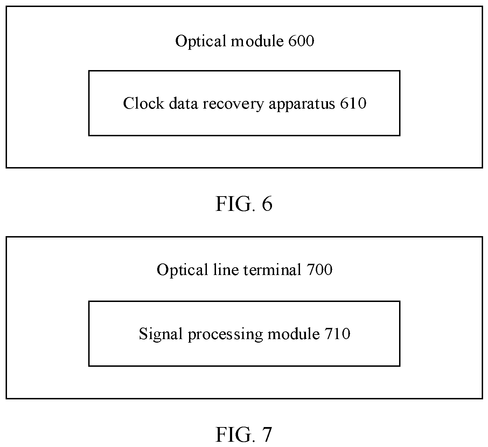

This application further provides an optical module. FIG. 6 shows a schematic structural diagram of the optical module. The optical module 600 may include a clock signal recovery apparatus 610, and the clock signal recovery apparatus 610 may be the clock data recovery apparatus shown in any one of FIG. 2 to FIG. 5.

This application further provides an optical line terminal. FIG. 7 shows a schematic structural diagram of the optical line terminal. The optical line terminal 700 may include a signal processing module 710. The signal processing module 710 may be the clock data recovery apparatus shown in any one of FIG. 2 to FIG. 5, or the optical module shown in FIG. 6.

A person of ordinary skill in the art may be aware that, in combination with the examples described in the embodiments disclosed in this specification, units may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by the person skilled in the art that, for the purpose of convenient and brief description, for a detailed working process of the foregoing device, apparatus and unit, refer to a corresponding process in the foregoing method embodiments, and details are not described herein again.

In the several embodiments provided in this application, it should be understood that the disclosed device, apparatus, and method may be implemented in other manners. For example, the described apparatus embodiment is merely an example. For example, division into the units is merely logical function division and may be other division in actual implementation. For example, a plurality of units or components may be combined or integrated into another unit, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of units. Some or all of the units may be selected based on actual requirements to achieve the objectives of the solutions of the embodiments.

In addition, functional units in the embodiments of this application may be integrated into one processing unit, or each of the units may exist alone physically, or two or more units are integrated into one unit.

The foregoing descriptions are merely specific implementations of this application, but are not intended to limit the protection scope of this application. Therefore, the protection scope of this application shall be subject to the protection scope of the claims.

## Claims

1. A clock data recovery apparatus (200), comprising a phase detection loop unit (210), a frequency oscillation unit (220), a frequency detection loop unit (230), a data collection unit (240) and a data detection unit (250), wherein
the data detection unit (250) is configured to: detect whether a data stream signal is input to the clock data recovery apparatus (200) and output an indication information to the phase detection loop unit (210) and the frequency detection loop unit (230); wherein, when detecting that the data stream signal is not input to the clock data recovery apparatus (200), the indication information indicates that the data stream signal is not input to the clock data recovery apparatus (200); and when detecting that the data stream signal is input to the clock data recovery apparatus (200), the indication information indicates that the data stream signal is input to the clock data recovery apparatus (200);
the frequency detection loop unit (230) is configured to: when the indication information output by the data detection unit (250) indicates that the data stream signal is not input to the clock data recovery apparatus (200), determine a first frequency difference between a reference clock signal and a signal output by the frequency oscillation unit (220), generate a first voltage signal based on the first frequency difference, and output the first voltage signal;
the frequency oscillation unit (220) is configured to: output a signal obtained by performing oscillation based on the first voltage signal and adjust a frequency of the signal based on the first voltage signal;
the phase detection loop unit (210) is configured to: when the indication information output by the data detection unit (250) indicates that the data stream signal is input to the clock data recovery apparatus (200), determine a phase difference between the data stream signal and the signal output by the frequency oscillation unit (220), generate a second voltage signal based on the phase difference, and output the second voltage signal;
the frequency oscillation unit (220) is further configured to: output a signal obtained by performing oscillation based on the second voltage signal and adjust a phase of the signal based on the second voltage signal; and
the data collection unit (240) is configured to collect, by using the signal obtained by performing oscillation based on the second voltage signal as a clock signal, a data signal in the data stream signal or in a signal obtained by delaying the data stream signal;
the clock data recovery apparatus (200) further comprises a loop lock detection unit (260), wherein
the loop lock detection unit (260) is configured to: determine a second frequency difference between the reference clock signal and the signal output by the frequency oscillation unit (230), and when determining that the second frequency difference is less than or equal to a preset threshold, output a first indication signal; and
the data detection unit (250) is specifically configured to: when the loop lock detection unit (260) outputs the first indication signal, start to detect whether the data stream signal is input to the clock data recovery apparatus (200);
wherein the frequency oscillation unit (220) comprises M frequency oscillators and a multiplexing unit, M is an integer greater than or equal to 2, and a frequency of the data stream signal falls within a total frequency range of signals that can be output by all of the M frequency oscillators; wherein
each of the M frequency oscillators is configured to: output a signal obtained by performing oscillation based on the first voltage signal;
the loop lock detection unit (260) is further configured to output a second indication signal to the multiplexing unit based on the second frequency difference between the reference clock signal and the signal output by the frequency oscillation unit (220); and
the multiplexing unit is configured to select, based on the second indication signal, the signal output by an i^{th} frequency oscillator in the M frequency oscillators as the output signal of the frequency oscillation unit (220), wherein a frequency difference between the signal output by the i^{th} frequency oscillator and the data stream signal is less than or equal to the preset threshold.

2. The clock data recovery apparatus according to claim 1, wherein
the data detection unit is configured to: when detecting a length of consecutive identical digits in the data stream signal meets a first condition, output the indication information indicating that the data stream signal is not input to the clock data recovery apparatus (200); and when detecting a length of consecutive identical digits in the data stream signal does not meet the first condition, output the indication information indicating that the data stream signal is input to the clock data recovery apparatus (200).

3. The clock data recovery apparatus (200) according to claim 1 or 2, wherein the phase detection loop unit (210) comprises a delay line unit, a first mixer, a second mixer, a voltage-to-current converter, and a first filter, wherein
the delay line unit is configured to delay the data stream signal; the first mixer is configured to perform frequency mixing on a signal obtained after delaying performed by the delay line unit and the data stream signal to obtain a first signal; the second mixer is configured to perform frequency mixing on the first signal and the signal output by the frequency oscillation unit (220) to obtain the phase difference; the voltage-to-current converter is configured to: when the data stream signal is input to the clock data recovery apparatus (200), convert the phase difference to a first current signal; and the first filter is configured to convert the first current signal to the second voltage signal.

4. The clock data recovery apparatus (200) according to claim 3, wherein the frequency detection loop unit (230) further comprises a first multiplexer, a second multiplexer, a delay calibration unit, and a first frequency divider, wherein
the first frequency divider is configured to divide a frequency of the signal output by the frequency oscillation unit by 2, to obtain a first frequency-divided signal and a second frequency-divided signal;
the delay calibration unit is configured to: after receiving the first indication signal, output a third indication signal to the first multiplexer and the second multiplexer;
the first multiplexer is configured to: after receiving the third indication signal, choose to output the first frequency-divided signal to the delay line unit;
the second multiplexer is configured to: after receiving the third indication signal, choose to output the second frequency-divided signal;
the delay calibration unit is further configured to: receive a signal output by the delay line unit and a signal output by the second multiplexer, and when a delay between the signal output by the delay line unit and the signal output by the second multiplexer is greater than a preset delay threshold, output a fourth indication signal to the delay line unit;
the delay line unit is configured to adjust a delay time based on the fourth indication signal;
the delay calibration unit is further configured to: when the delay between the signal output by the delay line unit and the signal output by the second multiplexer is less than or equal to the preset delay threshold, output a fifth indication signal to the first multiplexer and the second multiplexer, and output sixth indication signal to the data detection unit (250);
the first multiplexer is further configured to: after receiving the fifth indication signal, choose to output the data stream signal to the delay calibration unit;
the second multiplexer is further configured to: after receiving the fifth indication signal, choose to output the data stream signal to the delay calibration unit; and
the data detection unit (250) is specifically configured to: after receiving the sixth indication signal, start to detect whether the data stream signal is input to the clock data recovery apparatus (200).

5. The clock data recovery apparatus (200) according to any one of claims 1 to 4, wherein a frequency of the reference clock signal is 1/N of the frequency of the data stream signal, and
the clock data recovery apparatus (200) further comprises a frequency division unit, wherein the frequency division unit is configured to: divide the frequency of the signal output by the frequency oscillation unit by N to obtain a third frequency-divided signal, and output the third frequency-divided signal to the frequency detection loop unit (230); and
the frequency detection loop unit (230) is specifically configured to: when the data stream signal is not input to the clock data recovery apparatus (200), determine a frequency difference between the reference clock signal and the third frequency-divided signal, and use the frequency difference as the first frequency difference.

6. An optical module (600), comprising the clock data recovery apparatus (200) according to any one of claims 1 to 5.

7. An optical line terminal (700), comprising the clock data recovery apparatus (200) according to any one of claims 1 to 5 or the optical module (600) according to claim 6.

8. A passive optical network communications system, comprising the optical line terminal (700) according to claim 7.

## Patentansprüche

1. Taktdatenrückgewinnungsvorrichtung (200), die eine Phasendetektionsschleifeneinheit (210), eine Frequenzoszillationseinheit (220), eine Frequenzdetektionsschleifeneinheit (230), eine Datensammeleinheit (240) und eine Datendetektionseinheit (250) umfasst, wobei
die Datendetektionseinheit (250) für Folgendes ausgebildet ist: Erkennen, ob ein Datenstromsignal in die Taktdatenrückgewinnungsvorrichtung (200) eingegeben wird, und Ausgeben einer Anzeigeinformation an die Phasendetektionsschleifeneinheit (210) und die Frequenzdetektionsschleifeneinheit (230); wobei, wenn erkannt wird, dass das Datenstromsignal nicht in die Taktdatenrückgewinnungsvorrichtung (200) eingegeben wird, die Anzeigeinformation anzeigt, dass das Datenstromsignal nicht in die Taktdatenrückgewinnungsvorrichtung (200) eingegeben wird, und wenn erkannt wird, dass das Datenstromsignal in die Taktdatenrückgewinnungsvorrichtung (200) eingegeben wird, die Anzeigeinformation anzeigt, dass das Datenstromsignal in die Taktdatenrückgewinnungsvorrichtung (200) eingegeben wird,
die Frequenzdetektionsschleifeneinheit (230) für Folgendes ausgebildet ist: wenn die von der Datendetektionseinheit (250) ausgegebene Anzeigeinformation anzeigt, dass das Datenstromsignal nicht in die Taktdatenrückgewinnungsvorrichtung (200) eingegeben wird, Bestimmen einer ersten Frequenzdifferenz zwischen einem Referenztaktsignal und einem von der Frequenzoszillationseinheit (220) ausgegebenen Signal, Erzeugen eines ersten Spannungssignals auf der Grundlage der ersten Frequenzdifferenz, und Ausgeben des ersten Spannungssignals;
die Frequenzoszillationseinheit (220) für Folgendes ausgebildet ist: Ausgeben eines Signals, das durch Ausführen einer Oszillation auf der Grundlage des ersten Spannungssignals erhalten wird, und Einstellen einer Frequenz des Signals auf der Grundlage des ersten Spannungssignals;
die Phasendetektionsschleifeneinheit (210) für Folgendes ausgebildet ist: wenn die von der Datendetektionseinheit (250) ausgegebene Anzeigeinformation anzeigt, dass das Datenstromsignal in die Taktdatenrückgewinnungsvorrichtung (200) eingegeben wird, Bestimmen einer Phasendifferenz zwischen dem Datenstromsignal und dem von der Frequenzoszillationseinheit (220) ausgegebenen Signal, Erzeugen eines zweiten Spannungssignals auf der Grundlage der Phasendifferenz, und Ausgeben des zweiten Spannungssignals;
die Frequenzoszillationseinheit (220) ferner für Folgendes ausgebildet ist: Ausgeben eines Signals, das durch Ausführen einer Oszillation auf der Grundlage des zweiten Spannungssignals erhalten wird, und Einstellen einer Phase des Signals auf der Grundlage des zweiten Spannungssignals; und
die Datensammeleinheit (240) so ausgebildet ist, dass sie unter Verwendung des Signals, das durch die Durchführung der Oszillation auf der Grundlage des zweiten Spannungssignals als ein Taktsignal erhalten wurde, ein Datensignal in dem Datenstromsignal oder in einem Signal, das durch Verzögerung des Datenstromsignals erhalten wurde, sammelt;
die Taktdatenrückgewinnungsvorrichtung (200) ferner eine Schleifenverriegelungsdetektionseinheit (260) umfasst, wobei die Schleifenverriegelungsdetektionseinheit (260) für Folgendes ausgebildet ist:
Bestimmen einer zweiten Frequenzdifferenz zwischen dem Referenztaktsignal und dem von der Frequenzoszillationseinheit (230) ausgegebenen Signal, und wenn festgestellt wird, dass die zweite Frequenzdifferenz kleiner oder gleich einem voreingestellten Schwellenwert ist, Ausgeben eines ersten Anzeigesignals, und
die Datendetektionseinheit (250) speziell für Folgendes ausgebildet ist: wenn die Schleifenverriegelungsdetektionseinheit (260) das erste Anzeigesignal ausgibt, Beginnen zu erkennen, ob das Datenstromsignal in die Taktdatenrückgewinnungsvorrichtung (200) eingegeben wird,
wobei die Frequenzoszillationseinheit (220) M Frequenzoszillatoren und eine Multiplexiereinheit umfasst, M eine ganze Zahl größer oder gleich 2 ist, und eine Frequenz des Datenstromsignals in einen Gesamtfrequenzbereich von Signalen fällt, die von allen M Frequenzoszillatoren ausgegeben werden können; wobei jeder der M Frequenzoszillatoren für Folgendes ausgebildet ist:
Ausgeben eines Signals, das durch Ausführen einer Oszillation auf der Grundlage des ersten Spannungssignals erhalten wird,
die Schleifenverriegelungsdetektionseinheit (260) ferner so ausgebildet ist, dass sie ein zweites Anzeigesignal an die Multiplexiereinheit auf der Grundlage der zweiten Frequenzdifferenz zwischen dem Referenztaktsignal und dem von der Frequenzoszillationseinheit (220) ausgegebenen Signal ausgibt, und
die Multiplexiereinheit so ausgebildet ist, dass sie auf der Grundlage des zweiten Anzeigesignals, das von einem i^{-ten} Frequenzoszillator in den M Frequenzoszillatoren ausgegebene Signal als das Ausgangssignal der Frequenzoszillationseinheit (220) auswählt, wobei eine Frequenzdifferenz zwischen dem von dem i^{-ten} Frequenzoszillator ausgegebenen Signal und dem Datenstromsignal kleiner oder gleich dem voreingestellten Schwellenwert ist.

2. Taktdatenrückgewinnungsvorrichtung nach Anspruch 1, wobei die Datendetektionseinheit für Folgendes ausgebildet ist: wenn die Erkennung einer Länge von aufeinanderfolgenden identischen Ziffern im Datenstromsignal eine erste Bedingung erfüllt, Ausgeben der Anzeigeinformation, die anzeigt, dass das Datenstromsignal nicht in die Taktdatenrückgewinnungsvorrichtung (200) eingegeben wird, und wenn die Erkennung einer Länge von aufeinanderfolgenden identischen Ziffern im Datenstromsignal die erste Bedingung nicht erfüllt, Ausgeben der Anzeigeinformation, die anzeigt, dass das Datenstromsignal in die Taktdatenrückgewinnungsvorrichtung (200) eingegeben wird.

3. Taktdatenrückgewinnungsvorrichtung (200) nach Anspruch 1 oder 2, wobei die Phasendetektionsschleifeneinheit (210) eine Verzögerungsleitungseinheit, einen ersten Mischer, einen zweiten Mischer, einen Spannungs-Strom-Wandler und einen ersten Filter umfasst, wobei
die Verzögerungsleitungseinheit so ausgebildet ist, dass sie das Datenstromsignal verzögert; der erste Mischer so ausgebildet ist, dass er eine Frequenzmischung an einem Signal, das nach der von der Verzögerungsleitungseinheit durchgeführten Verzögerung erhalten wird, und dem Datenstromsignal durchführt, um ein erstes Signal zu erhalten; der zweite Mischer so ausgebildet ist, dass er eine Frequenzmischung des ersten Signals und des von der Frequenzoszillationseinheit (220) ausgegebenen Signals durchführt, um die Phasendifferenz zu erhalten; der Spannungs-Strom-Wandler für Folgendes ausgebildet ist: wenn das Datenstromsignal in die Taktdatenrückgewinnungsvorrichtung (200) eingegeben wird, Umwandeln der Phasendifferenz in ein erstes Stromsignal; und der erste Filter so ausgebildet ist, dass das erste Stromsignal in das zweite Spannungssignal umgewandelt wird.

4. Taktdatenrückgewinnungsvorrichtung (200) nach Anspruch 3, wobei die Frequenzdetektionsschleifeneinheit (230) ferner einen ersten Multiplexer, einen zweiten Multiplexer, eine Verzögerungskalibrierungseinheit und einen ersten Frequenzteiler umfasst, wobei
der erste Frequenzteiler so ausgebildet ist, dass er eine Frequenz des von der Frequenzoszillationseinheit ausgegebenen Signals durch 2 teilt, um ein erstes frequenzgeteiltes Signal und ein zweites frequenzgeteiltes Signal zu erhalten;
die Verzögerungskalibrierungseinheit für Folgendes ausgebildet ist: nach Empfang des ersten Anzeigesignals, Ausgeben eines dritten Anzeigesignals an den ersten Multiplexer und den zweiten Multiplexer,
der erste Multiplexer für Folgendes ausgebildet ist: nach Empfang des dritten Anzeigesignals, Wählen, um das erste frequenzgeteilte Signal an die Verzögerungsleitungseinheit auszugeben;
der zweite Multiplexer für Folgendes ausgebildet ist: nach Empfang des dritten Anzeigesignals, Wählen, um das zweite frequenzgeteilte Signal auszugeben;
die Verzögerungskalibrierungseinheit ferner für Folgendes ausgebildet ist: Empfangen eines von der Verzögerungsleitungseinheit ausgegebenen Signals und eines von dem zweiten Multiplexer ausgegebenen Signals, und wenn eine Verzögerung zwischen dem von der Verzögerungsleitungseinheit ausgegebenen Signal und dem vom zweiten Multiplexer ausgegebenen Signal größer ist als ein vorgegebener Verzögerungsschwellenwert, Ausgeben eines vierten Anzeigesignals an die Verzögerungsleitungseinheit,
die Verzögerungsleitungseinheit so ausgebildet ist, dass sie eine Verzögerungszeit auf der Grundlage des vierten Anzeigesignals einstellt;
die Verzögerungskalibrierungseinheit ferner für Folgendes ausgebildet ist: wenn die Verzögerung zwischen dem von der Verzögerungsleitungseinheit ausgegebenen Signal und dem vom zweiten Multiplexer ausgegebenen Signal kleiner oder gleich dem voreingestellten Verzögerungsschwellenwert ist, Ausgeben eines fünften Anzeigesignals an den ersten Multiplexer und den zweiten Multiplexer, und Ausgeben des sechsten Anzeigesignals an die Datendetektionseinheit (250);
der erste Multiplexer ferner für Folgendes ausgebildet ist: nach Empfang des fünften Anzeigesignals, Wählen, um das Datenstromsignal an die Verzögerungskalibrierungseinheit auszugeben;
der zweite Multiplexer ferner für Folgendes ausgebildet ist: nach Empfang des fünften Anzeigesignals, Wählen, um das Datenstromsignal an die Verzögerungskalibrierungseinheit auszugeben; und
die Datendetektionseinheit (250) speziell für Folgendes ausgebildet ist: nach Empfang des sechsten Anzeigesignals, Beginnen, um zu erkennen, ob das Datenstromsignal in die Taktdatenrückgewinnungsvorrichtung (200) eingegeben wird.

5. Taktdatenrückgewinnungsvorrichtung (200) nach einem der Ansprüche 1 bis 4, wobei eine Frequenz des Referenztaktsignals 1/N der Frequenz des Datenstromsignals ist, und
die Taktdatenrückgewinnungsvorrichtung (200) ferner eine Frequenzteilungseinheit umfasst, wobei die Frequenzteilungseinheit für Folgendes ausgebildet ist: Teilen der Frequenz des von der Frequenzoszillationseinheit ausgegebenen Signals durch N, um ein drittes frequenzgeteiltes Signal zu erhalten, und Ausgeben des dritten frequenzgeteilten Signals an die Frequenzdetektionsschleifeneinheit (230); und
die Frequenzdetektionsschleifeneinheit (230) speziell für Folgendes ausgebildet ist: wenn das Datenstromsignal nicht in die Taktdatenrückgewinnungsvorrichtung (200) eingegeben wird, Bestimmen einer Frequenzdifferenz zwischen dem Referenztaktsignal und dem dritten frequenzgeteilten Signal, und Verwenden der Frequenzdifferenz als erste Frequenzdifferenz.

6. Optikmodul (600), das die Taktdatenrückgewinnungsvorrichtung (200) nach einem der Ansprüche 1 bis 5 umfasst.

7. Optisches Leitungsendgerät (700), das die Taktdatenrückgewinnungsvorrichtung (200) nach einem der Ansprüche 1 bis 5 oder das Optikmodul (600) nach Anspruch 6 umfasst.

8. Passives optisches Netzwerk-Kommunikationssystem, das das optische Leitungsendgerät (700) nach Anspruch 7 umfasst.

## Revendications

1. Appareil de récupération de données d'horloge (200), comprenant une unité de boucle de détection de phase (210), une unité d'oscillation de fréquence (220), une unité de boucle de détection de fréquence (230), une unité de collecte de données (240) et une unité de détection de données (250),
l'unité de détection de données (250) étant configurée pour : détecter si un signal de flux de données est entré dans l'appareil de récupération de données d'horloge (200) et émettre une information d'indication vers l'unité de boucle de détection de phase (210) et l'unité de boucle de détection de fréquence (230) ; lors de la détection que le signal de flux de données n'est pas entré dans l'appareil de récupération de données d'horloge (200), les informations d'indication indiquant que le signal de flux de données n'est pas entré dans l'appareil de récupération de données d'horloge (200) ; et lors de la détection que le signal de flux de données est entré dans l'appareil de récupération de données d'horloge (200), les informations d'indication indiquant que le signal de flux de données est entré dans l'appareil de récupération de données d'horloge (200) ;
l'unité de boucle de détection de fréquence (230) étant configurée pour : lorsque les informations d'indication émises par l'unité de détection de données (250) indiquent que le signal de flux de données n'est pas entré dans l'appareil de récupération de données d'horloge (200), déterminer une première différence de fréquence entre un signal d'horloge de référence et un signal émis par l'unité d'oscillation de fréquence (220), générer un premier signal de tension sur la base de la première différence de fréquence, et émettre le premier signal de tension ;
l'unité d'oscillation de fréquence (220) étant configurée pour : émettre un signal obtenu en effectuant une oscillation sur la base du premier signal de tension et ajuster une fréquence du signal sur la base du premier signal de tension ;
l'unité de boucle de détection de phase (210) étant configurée pour : lorsque les informations d'indication émises par l'unité de détection de données (250) indiquent que le signal de flux de données est entré dans l'appareil de récupération de données d'horloge (200), déterminer une différence de phase entre le signal de flux de données et le signal émis par l'unité d'oscillation de fréquence (220), générer un deuxième signal de tension sur la base de la différence de phase, et émettre le deuxième signal de tension ;
l'unité d'oscillation de fréquence (220) étant en outre configurée pour : émettre un signal obtenu en effectuant une oscillation sur la base du deuxième signal de tension et ajuster une phase du signal sur la base du deuxième signal de tension ; et
l'unité de collecte de données (240) étant configurée pour collecter, en utilisant le signal obtenu en effectuant une oscillation sur la base du deuxième signal de tension comme signal d'horloge, un signal de données dans le signal de flux de données ou dans un signal obtenu en retardant le signal de flux de données ;
l'appareil de récupération de données d'horloge (200) comprenant en outre une unité de détection de verrouillage de boucle (260),
l'unité de détection de verrouillage de boucle (260) étant configurée pour : déterminer une deuxième différence de fréquence entre le signal d'horloge de référence et le signal émis par l'unité d'oscillation de fréquence (230), et lorsqu'elle détermine que la deuxième différence de fréquence est inférieure ou égale à un seuil prédéfini, émettre un premier signal d'indication ; et
l'unité de détection de données (250) étant spécifiquement configurée pour : lorsque l'unité de détection de verrouillage de boucle (260) émet le premier signal d'indication, commencer à détecter si le signal de flux de données est entré dans l'appareil de récupération de données d'horloge (200) ;
l'unité d'oscillation de fréquence (220) comprenant M oscillateurs de fréquence et une unité de multiplexage, M étant un nombre entier supérieur ou égal à 2, et une fréquence du signal de flux de données se situant dans une plage de fréquence totale de signaux pouvant être émis par tous les M oscillateurs de fréquence ;
chacun des M oscillateurs de fréquence étant configuré pour : émettre un signal obtenu en effectuant une oscillation sur la base du premier signal de tension ;
l'unité de détection de verrouillage de boucle (260) étant en outre configurée pour émettre un deuxième signal d'indication vers l'unité de multiplexage sur la base de la deuxième différence de fréquence entre le signal d'horloge de référence et le signal émis par l'unité d'oscillation de fréquence (220) ; et
l'unité de multiplexage étant configurée pour sélectionner, sur la base du deuxième signal d'indication, le signal émis par un i^{ème} oscillateur de fréquence dans les M oscillateurs de fréquence comme signal de sortie de l'unité d'oscillation de fréquence (220), une différence de fréquence entre le signal émis par le i^{ème} oscillateur de fréquence et le signal de flux de données étant inférieure ou égale au seuil prédéfini.

2. Appareil de récupération de données d'horloge selon la revendication 1, l'unité de détection de données étant configurée pour : lorsque la détection d'une longueur de chiffres identiques consécutifs dans le signal de flux de données répond à une première condition, émettre les informations d'indication indiquant que le signal de flux de données n'est pas entré dans l'appareil de récupération de données d'horloge (200) ; et lorsque la détection d'une longueur de chiffres identiques consécutifs dans le signal de flux de données ne répond pas à la première condition, émettre les informations d'indication indiquant que le signal de flux de données est entré dans l'appareil de récupération de données d'horloge (200).

3. Appareil de récupération de données d'horloge (200) selon la revendication 1 ou 2, l'unité de boucle de détection de phase (210) comprenant une unité de ligne à retard, un premier mélangeur, un deuxième mélangeur, un convertisseur tension-courant et un premier filtre,
l'unité de ligne à retard étant configurée pour retarder le signal de flux de données ; le premier mélangeur étant configuré pour effectuer un mélange de fréquences sur un signal obtenu après le retard effectué par l'unité de ligne à retard et le signal de flux de données pour obtenir un premier signal ; le deuxième mélangeur étant configuré pour effectuer un mélange de fréquences sur le premier signal et le signal émis par l'unité d'oscillation de fréquence (220) afin d'obtenir la différence de phase ; le convertisseur tension-courant étant configuré pour : lorsque le signal de flux de données est entré dans l'appareil de récupération des données d'horloge (200), convertir la différence de phase en un premier signal de courant ; et le premier filtre étant configuré pour convertir le premier signal de courant en le deuxième signal de tension.

4. Appareil de récupération de données d'horloge (200) selon la revendication 3, l'unité de boucle de détection de fréquence (230) comprenant en outre un premier multiplexeur, un deuxième multiplexeur, une unité d'étalonnage de retard, et un premier diviseur de fréquence,
le premier diviseur de fréquence étant configuré pour diviser par 2 une fréquence du signal émis par l'unité d'oscillation de fréquence, afin d'obtenir un premier signal divisé en fréquence et un deuxième signal divisé en fréquence ;
l'unité d'étalonnage de retard étant configurée pour : après avoir reçu le premier signal d'indication, émettre un troisième signal d'indication vers le premier multiplexeur et le deuxième multiplexeur ;
le premier multiplexeur étant configuré pour : après avoir reçu le troisième signal d'indication, choisir d'émettre le premier signal divisé en fréquence vers l'unité de ligne à retard ;
le deuxième multiplexeur étant configuré pour : après avoir reçu le troisième signal d'indication, choisir d'émettre le deuxième signal divisé en fréquence ;
l'unité d'étalonnage de retard étant en outre configurée pour : recevoir un signal émis par l'unité de ligne à retard et un signal émis par le deuxième multiplexeur, et lorsqu'un retard entre le signal émis par l'unité de ligne à retard et le signal émis par le deuxième multiplexeur est supérieur à un seuil de retard prédéfini, émettre un quatrième signal d'indication vers l'unité de ligne à retard ;
l'unité de ligne à retard étant configurée pour ajuster un temps de retard sur la base du quatrième signal d'indication ;
l'unité d'étalonnage de retard étant en outre configurée pour : lorsque le retard entre le signal émis par l'unité de ligne à retard et le signal émis par le deuxième multiplexeur est inférieur ou égal au seuil de retard prédéfini, émettre un cinquième signal d'indication vers le premier multiplexeur et vers le deuxième multiplexeur, et émettre un sixième signal d'indication vers l'unité de détection de données (250) ;
le premier multiplexeur étant en outre configuré pour : après avoir reçu le cinquième signal d'indication, choisir d'émettre le signal de flux de données vers l'unité d'étalonnage de retard ;
le deuxième multiplexeur étant en outre configuré pour : après avoir reçu le cinquième signal d'indication, choisir d'émettre le signal de flux de données vers l'unité d'étalonnage de retard ; et
l'unité de détection de données (250) étant spécifiquement configurée pour : après avoir reçu le sixième signal d'indication, commencer à détecter si le signal de flux de données est entré dans l'appareil de récupération de données d'horloge (200).

5. Appareil de récupération de données d'horloge (200) selon l'une quelconque des revendications 1 à 4, une fréquence du signal d'horloge de référence étant 1/N de la fréquence du signal de flux de données, et
l'appareil de récupération de données d'horloge (200) comprenant en outre une unité de division de fréquence, l'unité de division de fréquence étant configurée pour :
diviser la fréquence du signal émis par l'unité d'oscillation de fréquence par N afin d'obtenir un troisième signal divisé en fréquence, et émettre le troisième signal divisé en fréquence vers l'unité de boucle de détection de fréquence (230) ; et
l'unité de boucle de détection de fréquence (230) étant spécifiquement configurée pour : lorsque le signal de flux de données n'est pas entré dans l'appareil de récupération de données d'horloge (200), déterminer une différence de fréquence entre le signal d'horloge de référence et le troisième signal divisé en fréquence, et utiliser la différence de fréquence comme première différence de fréquence.

6. Module optique (600), comprenant l'appareil de récupération de données d'horloge (200) selon l'une quelconque des revendications 1 à 5.

7. Terminal de ligne optique (700), comprenant l'appareil de récupération de données d'horloge (200) selon l'une quelconque des revendications 1 à 5 ou le module optique (600) selon la revendication 6.

8. Système de communication de réseau optique passif, comprenant le terminal de ligne optique (700) selon la revendication 7.
